# EUROPEAN PATENT SPECIFICATION

(11) **EP 3 269 042 B1**
(45) Date of publication and mention of the grant of the patent: **09.01.2019**
(21) Application number: 15797466.8
(22) Date of filing: 08.04.2015
(51) Int. Cl.: H03M 7/30

(54) **DATA REDUCTION METHOD AND APPARATUS**
VERFAHREN UND VORRICHTUNG ZUR DATENREDUZIERUNG
PROCÉDÉ ET APPAREIL DE RÉDUCTION DE DONNÉES

(43) Date of publication of application: 17.01.2018
(73) Proprietor: Siemens Aktiengesellschaft, 80333 München (DE)
(72) Inventor: PYAYT, Alexander Leonidovich, St.Petersburg 198207 (RU); ZOBNIN, Sergey Sergeyevich, St.Petersburg 196158 (RU)
(86) International application number: PCT/RU2015/000229
(87) International publication number: WO 2016/163908

(56) References cited:
- AU-A1- 2004 242 419
- US-A1- 2010 115 013
- US-B1- 6 789 052
- "Linear Data Compression", internet article, 6 October 1999 (1999-10-06), XP002753485, Retrieved from the Internet: URL:https://www.willamette.edu/~gorr/class es/cs449/Unsupervised/pca.html [retrieved on 2016-01-27]
- ASHWINI REDDY T ET AL: "Nonlinear principal component analysis for seismic data compression", RECENT ADVANCES IN INFORMATION TECHNOLOGY (RAIT), 2012 1ST INTERNATIONAL CONFERENCE ON, IEEE, 15 March 2012 (2012-03-15), pages 927-932, XP032177808, DOI: 10.1109/RAIT.2012.6194558 ISBN: 978-1-4577-0694-3
- Christos Anagnostopoulos et al: "Context Compression: using Principal ComponentAnalysis for Efficient Wireless Communications", Mobile Data Management (MDM), 2011 12th IEEE International Conference on, vol. 1 9 June 2011 (2011-06-09), XP002753492, Retrieved from the Internet: URL:http://ieeexplore.ieee.org/stamp/stamp .jsp?tp=&arnumber=6068440 [retrieved on 2016-01-27]

## Description

The present invention relates to a method and an apparatus for reducing data. In particular, the present invention relates to reducing an amount of highly correlated data.

### Related art

The document "Linear Data Compression" (retrieved from the Internet https//www.willmette.edu/~gorr/classes/cs449/ Unsupervised/pcs.htm on January 27, 2016) discloses compression of data using Principal Component Analysis (PCA).

Many modern technical systems deal with a high amount of digital information. In particular, the amount of digital information which is produced by modern technical systems increases more and more rapidly. For example, the resolution of images becomes higher, or measurement data provided by sensors supervising a technical system increase by increasing the number of sensors and/or the resolution of each sensor. In many cases, data are highly correlated or even similar. For instance, a plurality of images may have a common image data base, or a plurality of redundant sensors are monitoring a same object. This increasing amount of data leads to at least the following two problems: a huge amount of data has to be stored, and a huge amount of data has to be transmitted between a data source and further components for processing the data. Conventional compression algorithm usually only provide limited compression rates.

Hence, there is a need to get along with this increasing amount of data. Consequently, there is a need to reduce the amount of data, in particular to reduce an amount of highly correlated data.

### Summary of the invention

This is achieved by the features of the independent claims. The present invention takes into account that data very often are highly correlated or similar. In particular, the data of technical systems like redundant sensors monitoring the same object will be very similar. For instance, a plurality of sensors monitoring the same object may only differ by an amplitude or a phase.

The present invention takes into account this observation and provides enhanced data reduction for such highly correlated data. In particular, the present invention provides a data reduction apparatus and method which exploits information from the data to be compressed. Hence, it is possible to achieve a much better compression ratio than by compressing data using conventional or standard compression methods. By taking into account information in the data itself during the data reduction, a high compression ratio can be achieved while maintaining a high quality after reconstructing the reduced data. Even though a loss or data compression is applied to the original data, the loss of information during the compression and reconstruction is low.

According to an embodiment, the set of data which is obtained for data reduction comprises a plurality of data streams.

According to a further embodiment, the step of obtaining a set of data comprises or consists of obtaining data from a plurality of sensors. However, further data sources for providing data streams are possible, too.

By subjecting data from a plurality of data streams, in particular a plurality of highly correlated data streams, to the above-described data reduction, a very efficient reduction of data can be achieved with a minimum loss of information. In this way, technical systems for monitoring complex apparatus may be possible, even though the resources for storing and/or data transmission may be limited.

According to a further embodiment, the groups of identified correlated data comprise groups of correlated data streams.

Hence, the data to be reduced is divided into a plurality of correlated data streams. Such a plurality of correlated data streams can be subjected to a very efficient data reduction.

According to a further embodiment, the step of identifying groups of correlated data comprises linear correlation calculation, or a cluster analysis. In particular, the step of identifying groups of correlated data may comprise density-based clustering or centroid-based clustering.

Such an identification of correlated data by a correlation value or a cluster analysis is a very efficient method for identifying similarities in the data to be reduced.

According to a further embodiment, spectral dimensionality decomposition comprises principal component analysis, independent component analysis and/or local component analysis.

Such a spectral dimensionality decomposition is a very efficient method for specifying the characteristics of a plurality of series of data.

According to a further embodiment of the data reduction apparatus, the apparatus further comprises a memory for storing the spectral dimensionality decomposition components and factors; and the reconstruction unit is adapted to reconstruct the set of data based on the stored spectral decomposition components and factors in the memory.

In this way, the amount of data can be reduced before storing the data. Hence, the required storage capacity of the memory can be reduced even though the data can be provided in high quality after reading and reconstruction.

According to a further embodiment, the apparatus further comprises a transmitting unit adapted to transmit the spectral decomposition components and factors.

Hence, a high amount of data can be transmitted via a transmission line providing only a limited bandwidth.

According to a further aspect, the present invention provides a data reconstruction apparatus comprising a receiving unit adapted to receive spectral decomposition components and factors transmitted by a data reduction apparatus according to the present invention; and a reconstruction unit adapted to reconstruct the set of data based on the received spectral decomposition components and factors.

In this way, the data can be provided in a high quality after transmitting a high amount of data via a transmission line providing only a limited bandwidth.

According to a further aspect, the present invention provides a measurement system comprising a plurality of sensors, wherein each sensor is adapted to provide a data stream; and a data reconstruction apparatus according to the present invention. The data reconstruction apparatus is adapted to perform a data reduction of data streams provided by the plurality of sensors of the measurement system.

According to a further aspect, the present invention provides a computer program product adapted to perform the data reduction method according to the present invention.

Further advantages and embodiments will become apparent by the following description in connection with the accompanying drawings, wherein:
- Figure 1: shows a schematic illustration of a data reduction apparatus according to an embodiment; and
- Figure 2: shows a flowchart of a data reduction method underlying a data reduction method according to an embodiment.

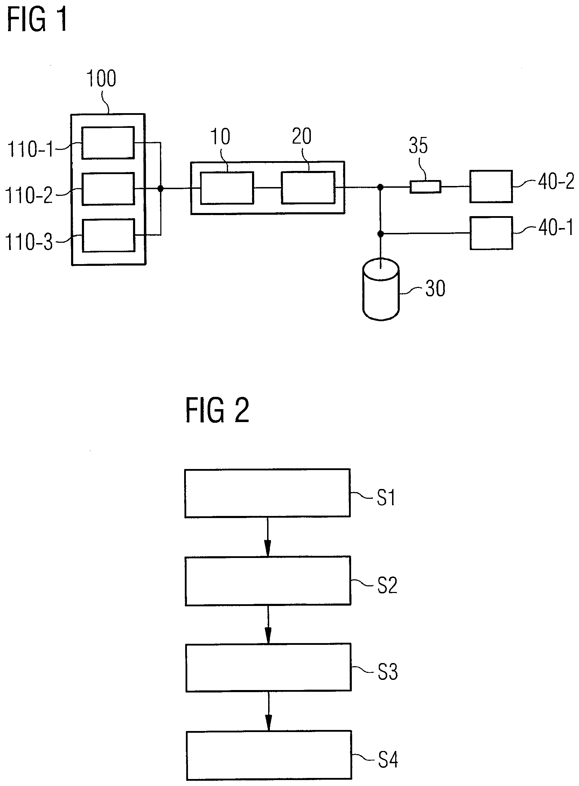

Figure 1 shows a schematic illustration of a data reduction apparatus for reducing the amount of data provided by a data source 100. For instance, the data source 100 may be any technical system, such as a manufacturing facility, a power plant, in particular a gas turbine, etc. Such a technical system may be monitored by a plurality of sensors 110-i. In order to enhance the reliability of the data provided by the sensors 110-i, a plurality of redundant sensors may be employed in some cases. In this case, the data output by the redundant sensors 110-i may be similar or almost the same. However, it may be also possible that output signal of different sensors 110-i are correlated, too. For instance, a first sensor 110-i may monitor a voltage and a second sensor 110-i may monitor a current. Further, a third sensor may monitor the rotational speed of a generator providing the monitored voltage and current. In such a case there will be also some similarities between rotational speed, current and voltage. Even though there are only three sensors shown in Figure 1, data source 100 may comprise much more sensors 110-i, and the present invention is not limited to only three sensors 110-i. Additionally, the present invention is also not limited to sensors for monitoring voltage, current or rotational speed. Any other type of sensor or data source providing digital information or analogue information which will be converted to digital information by an analogue to digital converter, is possible, too.

Preferably, the data output by the sensors 110-i of the data source 100 are provided as continuous data streams. However, the data are not limited to data streams. Any other format of data may be possible, too.

In order to reduce the amount of data provided by data source 100, the data is provided to a data reduction apparatus. The data reduction apparatus may comprise at least a similarity identification unit 10 and a spectral dimensionality decomposition unit 20. The similarity identification unit 10 receives the data provided by data source 100. If necessary, all data, in particular all data streams of the individual sensors 110-i, may be adapted. For instance, the resolution, the sampling rate, etc. may be adapted in order to obtain a unique basis for all input data.

Similarity identification unit 10 analyses the obtained data form data source 10 in order to identify groups of correlated data. For instance, similarity identification unit 10 of the data reduction apparatus may perform a linear correlation calculation. In order to identify groups of correlated data in the data obtained from data source 100, it may be possible to calculate correlation value of the individual data segments or data streams from data source 100. If the correlation value exceeds a predetermined value, the data are considered to be similar. Such groups of a data are identified as correlated data. However, any other method for determining groups of correlated data are possible.

For example, it may also possible to perform a cluster analysis of the obtained data from data source 100. Cluster analysis is a task of grouping a set of objects in such a way that objects in the same group are more similar to each other than to those in other groups. It is a main task of exploratory data mining, and a common technique for statistical data analysis, used in many fields.

Cluster analysis can be achieved by various algorithms that differ significantly in their notion of what constitutes a cluster. Popular notions of clusters include groups with small distances among the cluster members, dense areas of the data space, intervals or particular statistical distributions. Cluster analysis can therefore be formulated as a multi-objective optimization problem. The appropriate clustering algorithm and parameter settings depend on the individual data set and intended use of the results. Cluster usually is an iterative process of knowledge discovery or interactive multi-objective optimization that involves trial and failure. It will often be necessary to modify data preprocessing and model parameters until the result achieves the desired properties.

For instance density-based clustering or a centroid-based clustering may be used to identify similarities in the obtained data from the plurality of sensor data from sensors 110-i.

In centroid-based clustering, clusters are represented by a central vector, which may not necessarily be a member of the data set. For instance, when the number of clusters is fixed to k, k-means clustering gives a formal definition as an optimization problem: find the k cluster centers and assign the objects to the nearest cluster center, such that the squared distances from the cluster are minimized.

The common approach is to search only for approximate solutions. An example of a particularly well known approximatively method is Lloyd's algorithm, which is also referred to as "k-means algorithm". Variations of k-means may include optimizations as choosing the best of multiple runs, but also restricting the centroids to members of the data set, choosing medians, choosing the initial centers less randomly or allowing a fuzzy cluster assignment.

In density-based clustering, clusters are defined as areas of higher density than the remainder of the data set. Objects in these sparse areas - that are required to separate clusters - are usually considered to be noise and border points. A well-known density based clustering method is DBSCAN (density-based spatial clustering of applications with noise).

Even though it is possible to apply the data reduction according to the present invention to periodical time streams, the present invention is not limited to such periodical time streams. Non periodical data streams are possible, too.

Next, a spectral dimensionality reduction is applied to the identified correlated data in spectral dimensional data composition unit 20. For instance, a principal component analysis may be applied to the identified groups of correlated data. Such a principal component analysis (PCA) is a statistical procedure that uses an orthogonal transformation to convert a set of observations of possibility correlated variables into a set of values of linearity uncorrelated variables called principal components. The number of principal components is less than or equal to the number of original variables. Hence, the amount of data can be reduced. The transformation is defined in such a way that the first principal component has the largest possible variance, and each succeeding component in turn has the highest variance possible under the constraint that it is orthogonal to the preceding components.

After a principal component analysis of the identified correlated data has been performed, the first principal components are used to encode and decode data. In other words, principal components and the coefficients are output instead of the whole data provided by data source 100. In this way, the amount of data is reduced with respect to the data provided by data source 100. Since highly correlated data are subjected to such a spectral dimensionality decomposition, the output data of the data reduction apparatus comprises only the whole data (e.g. as encoded PCA components) of uncorrelated data streams, while the remaining data can be specified by a few additional principal components.

In other words, the data reduction apparatus first performs a training phase in order to identify similar sets of data, in particular data streams. After such a training phase, only a single data stream has to be fully encoded, while the remaining data streams of a plurality of similar data streams are specified by only encoding deviations with respect to the transmitted data stream. Hence, a data reduction of a high amount of input data is performed by taking into account characteristics of the input data, in particular with respect to the temporal sequence of the data streams. For a plurality of similar data streams, only a single data stream is to be transmitted or stored (in an encoded form), while the remaining data streams are transmitted or stored by encoding only deviations.

Even though the spectral dimensional decomposition has been described in the previous description with respect to a principal component analysis, it may be also possible to apply an independent component analysis (ICA) or a local component analysis (LCA). Further algorithms for spectral dimensionality decomposition are possible, too.

After a data reduction has been applied to the data provided by data source 100, the data can be transmitted via a transmission line 35 and/or stored in a memory 30. If the reduced data are stored in a memory 30, the reduced data may be reconstructed by reconstruction unit 40-1. In this case, reconstruction unit 40-1 reads the data from memory 30 and performs a reconstruction of the set of data based on the store spectral decomposition components and factors in this memory. After this, all data (data streams) can be provided in the original (i.e. uncompressed) format. Even though the data reconstruction as described before is a lossy compression, there is only a minimum data loss since the compression of the data takes into account information from the data itself when reducing the amount of data.

According to an alternative embodiment, the data may be transmitted via a transmission line 35 after reducing the amount of data. In this case, the reduced data may be received by a receiving unit 40-2 at the other end of the transmission line 35 and subsequently, a reconstruction of the reduced data may be performed in order to obtain all data (data streams) in their original data format (uncompressed).

According to a further embodiment, the reduced data may be further processed without reconstruction. For instance, the components and factors of the spectral dimensionality decomposition may be directly used for a further processing of the reduced data without uncompressing the encoded data. In particular, if a subsequent processing may be require components and factors of a spectral dimensionality decomposition, it is not necessary to perform such a spectral decomposition again.

Hence, a subsequent analysis of the data may be performed based on the encoded data having a reduced amount of data. In this way, the previous processing of the data from data source 100 can be used in order to simplify and speedup a further processing. By using the data of the principal component analysis or the independent component analysis or the local component analysis in a subsequent processing, it is not necessary to apply such an analysis once again.

Figure 2 shows a flowchart illustrating a data reduction method according to an embodiment of the present invention. In a first step S1 a set of data is obtained. The obtained data may be, for instance, a plurality of data streams, such as data streams output by sensors 110-i of data source 100.

Subsequently, groups of correlated data may be identified in step S2. For instance, the groups of identified data may comprise groups of correlated data streams.

The identification of groups of correlated data may be performed by a linear correlation calculation or a clustering. For example, the clustering may be a density-based clustering and/or a centroid-based clustering. Any other method for identifying correlated data is possible, too.

Next, in step S3 a spectral dimensionality decomposition for the groups of correlated data is performed. In this way, spectral decomposition components and factors are obtained. As already outlined above, the spectral dimensionality decomposition may be performed by a principal component analysis, an independent component analysis and/or a local component analysis.

After this, the obtained spectral decomposition components and factors are output in step S4 as encoded data. In particular, the whole components and factors of a single element of the group of correlated data are output, while only components and factors specifying differences to this single element are output for the remaining elements of the group. The output spectral decomposition components may be stored in a memory 30 or may be transmitted via a transmission line 35.

In order to further deal with the data, a data reconstruction may be performed based on the components and factors of the spectral dimensionality decomposition. Alternatively, the spectral decomposition components and factors may be directly used for a further processing and analysis of the data.

Summarizing, the present invention provides a data reduction for reducing highly correlated data, in particular highly correlated data streams. For this purpose, correlated data of a plurality of data streams are identified and a spectral dimensional decomposition is performed. In this way, it is possible to exploit information from the data of the data streams and to use this information in order to achieve a highly efficient reduction of the data. In this way, the compression ratio of the data can be enhanced or the data loss of the reduce data compression can be minimized.

## Claims

1. A data reduction method, comprising the steps of:
obtaining (S1) a set of data;
identifying (S2) groups of correlated data in the set of data;
performing (S3) a spectral dimensionality decomposition for the identified groups of correlated data in order to obtain spectral decomposition components and factors; and
outputting (S4) the obtained spectral decomposition components and factors,
wherein the whole components and factors of a single element of the group of correlated data are output, and only components and factors specifying differences to the single element are output for the remaining elements of the group.

2. The method according to claim 1, wherein the set of data comprises a plurality of data streams.

3. The method according to claim 1 or 2, wherein the step (S1) of obtaining a set of data comprises obtaining data from a plurality of sensors (110-i).

4. The method according to any of claims 1 to 3, wherein the groups of identified correlated data comprise groups of correlated data streams.

5. The method according to any of claims 1 to 4, wherein the step of identifying groups of correlated data comprises linear correlation calculation or a cluster analysis.

6. The method according to any of claims 1 to 5, wherein spectral dimensionality decomposition comprises principal component analysis, independent component analysis and/or local component analysis.

7. A data reduction apparatus for reducing the amount of data in a set of data, the apparatus comprising:
a similarity identification unit (10) adapted to identify groups of correlated data in the set of data; and
a spectral dimensionality decomposition unit (20), adapted to perform a spectral dimensionality decomposition for the identified groups of correlated data and provide spectral decomposition components and factors,
wherein the whole components and factors of a single element of the group of correlated data are output, and only components and factors specifying differences to the single element are output for the remaining elements of the group.

8. The data reduction apparatus according to claim 7, further comprising a memory (30) for storing the spectral decomposition components and factors; and
a reconstruction unit (40-1) adapted to reconstruct the set of data based on the stored spectral decomposition components and factors in the memory (30).

9. The data reduction apparatus according to claim 7 or 8, further comprising a transmitting unit (35) adapted to transmit the spectral decomposition components and factors.

10. A data reconstruction apparatus comprising:
a receiving unit adapted to receive spectral decomposition components and factors transmitted by the data reduction apparatus according to claim 9; and
a reconstruction unit (40-2) adapted to reconstruct the set of data based on the received spectral decomposition components and factors.

11. A measurement system comprising:
a plurality of sensors (110-i), wherein each sensor (110-i) is adapted to provide a data stream; and
the data reduction apparatus according to any of claims 7 to 9, wherein the data reduction apparatus is adapted to perform a data reduction of the data streams provided by the plurality of sensors (110-i).

12. A computer program product adapted to perform the method according to any of claims 1 to 6.

## Patentansprüche

1. Datenreduktionsverfahren, das folgende Schritte umfasst:
Erhalten (S1) eines Datensatzes;
Identifizieren (S2) von Gruppen korrelierter Daten im Datensatz;
Durchführen (S3) einer Spektraldimensionszerlegung für die identifizierten Gruppen korrelierter Daten, um Spektralzerlegungskomponenten und -faktoren zu erhalten; und
Ausgeben (S4) der erhaltenen Spektralzerlegungskomponenten und -faktoren,
wobei die gesamten Komponenten und Faktoren eines einzelnen Elements der Gruppe korrelierter Daten ausgegeben werden und nur Komponenten und Faktoren, die Unterschiede zum einzelnen Element angeben, für die übrigen Elemente der Gruppe ausgegeben werden.

2. Verfahren nach Anspruch 1, wobei der Datensatz eine Vielzahl von Datenströmen umfasst.

3. Verfahren nach Anspruch 1 oder 2, wobei Schritt (S1) des Erhaltens eines Datensatzes Erhalten von Daten von einer Vielzahl von Sensoren (110-i) umfasst.

4. Verfahren nach einem der Ansprüche 1 bis 3, wobei die Gruppen identifizierter korrelierter Daten Gruppen korrelierter Datenströme umfassen.

5. Verfahren nach einem der Ansprüche 1 bis 4, wobei der Schritt des Identifizierens von Gruppen korrelierter Daten eine Linearkorrelationskalkulation oder eine Clusteranalyse umfasst.

6. Verfahren nach einem der Ansprüche 1 bis 5, wobei die Spektraldimensionszerlegung eine Principal Component Analysis, eine Independent Component Analysis und/oder eine Local Component Analysis umfasst.

7. Datenreduktionsvorrichtung zum Reduzieren der Menge von Daten in einem Datensatz, wobei die Vorrichtung Folgendes umfasst:
eine Ähnlichkeitsidentifizierungseinheit (10), die zum Identifizieren von Gruppen korrelierter Daten im Datensatz ausgelegt ist; und
eine Spektraldimensionszerlegungseinheit (20), die zum Durchführen einer Spektraldimensionszerlegung für die identifizierten Gruppen korrelierter Daten und zum Bereitstellen von Spektralzerlegungskomponenten und -faktoren ausgelegt ist,
wobei die gesamten Komponenten und Faktoren eines einzelnen Elements der Gruppe korrelierter Daten ausgegeben werden und nur Komponenten und Faktoren, die Unterschiede zum einzelnen Element angeben, für die übrigen Elemente der Gruppe ausgegeben werden.

8. Datenreduktionsvorrichtung nach Anspruch 7, die ferner ein Speicherelement (30) zum Speichern der Spektralzerlegungskomponenten und -faktoren umfasst; und
eine Rekonstruktionseinheit (40-1), die zum Rekonstruieren des Datensatzes basierend auf den gespeicherten Spektralzerlegungskomponenten und -faktoren im Speicherelement (30) ausgelegt ist.

9. Datenreduktionsvorrichtung nach Anspruch 7 oder 8, die ferner eine Übertragungseinheit (35), die zum Übertragen der Spektralzerlegungskomponenten und -faktoren ausgelegt ist, umfasst.

10. Datenrekonstruktionsvorrichtung, die Folgendes umfasst:
eine Empfangseinheit, die zum Empfangen von durch die Datenreduktionsvorrichtung nach Anspruch 9 übertragenen Spektralzerlegungskomponenten und -faktoren ausgelegt ist; und
eine Rekonstruktionseinheit (40-2), die zum Rekonstruieren des Datensatzes basierend auf den empfangenen Spektralzerlegungskomponenten und -faktoren ausgelegt ist.

11. Messsystem, das Folgendes umfasst:
eine Vielzahl von Sensoren (110-i), wobei jeder Sensor (110-i) zum Bereitstellen eines Datenstroms ausgelegt ist; und
die Datenreduktionsvorrichtung nach einem der Ansprüche 7 bis 9, wobei die Datenreduktionsvorrichtung zum Durchführen einer Datenreduktion der durch die Vielzahl von Sensoren (110-i) bereitgestellten Datenströme ausgelegt ist.

12. Computerprogrammprodukt, das zum Durchführen des Verfahrens nach einem der Ansprüche 1 bis 6 ausgelegt ist.

## Revendications

1. Procédé de réduction de données comprenant les stades dans lesquels :
on obtient (S1) un jeu de données ;
on identifie (S2) des groupes de données corrélées dans le jeu de données ;
on effectue (S3) une décomposition de dimensionnalité spectrale pour les groupes identifiés de données corrélées, afin d'obtenir des composantes et des facteurs de décomposition spectrale et
on sort (S4) les composantes et les facteurs de décomposition spectrale obtenus,
dans lequel tous les composantes et facteurs d'un élément unique du groupe de données corrélées sont sortis et seulement des composantes et des facteurs précisant des différences par rapport à l'élément unique sont sortis pour les éléments restants du groupe.

2. Procédé suivant la revendication 1, dans lequel le jeu de données comprend une pluralité de trains de données.

3. Procédé suivant la revendication 1 ou 2, dans lequel le stade (S1) d'obtention d'un jeu de données comprend obtenir des données d'une pluralité de capteurs (110-i).

4. Procédé suivant l'une quelconque des revendications 1 à 3, dans lequel les groupes de données corrélées identifiés comprennent des groupes de trains de données corrélées.

5. Procédé suivant l'une quelconque des revendications 1 à 4, dans lequel le stade d'identification de groupes de données corrélées comprend un calcul de corrélation linéaire ou une analyse de groupe.

6. Procédé suivant l'une quelconque des revendications 1 à 5, dans lequel la décomposition de dimensionnalité spectrale comprend une analyse de composantes principales, une analyse de composantes indépendantes et/ou une analyse de composantes locales.

7. Dispositif de réduction de données pour réduire la quantité de données d'un jeu de données, le dispositif comprenant :
une unité (10) d'identification de similarité conçue pour identifier des groupes de données corrélées du jeu de données et
une unité (20) de décomposition de dimensionnalité spectrale conçue pour effectuer une décomposition de dimensionnalité spectrale pour les groupes identifiés de données corrélées et fournir des composantes et des facteurs de décomposition spectrale,
dans lequel tous les composantes et facteurs d'un élément unique du groupe de données corrélées sont sortis et seulement des composantes et des facteurs précisant des différences par rapport à l'élément unique sont sortis pour les éléments restants du groupe.

8. Dispositif de réduction de données suivant la revendication 7, comprenant, en outre, une mémoire (30) pour mettre en mémoire les composantes et facteurs de décomposition spectrale et
une unité (40-1) de reconstruction conçue pour reconstruire le jeu de données sur la base des composantes et des facteurs de décomposition spectrale mis en mémoire dans la mémoire (30).

9. Dispositif de réduction de données suivant la revendication 7 ou 8, comprenant, en outre, une unité (35) d'émission conçue pour émettre les composantes et facteurs de décomposition spectrale.

10. Dispositif de reconstruction de données comprenant :
une unité de réception conçue pour recevoir des composantes et facteurs de décomposition spectrale émis par le dispositif de réduction de données suivant la revendication 9 et
une unité (40-2) de reconstruction conçue pour reconstruire le jeu de données sur la base des composantes et facteurs de décomposition spectrale qui ont été reçus.

11. Système de mesure comprenant :
une pluralité de capteurs (110-i), chaque capteur (110-i) étant conçu pour fournir un train de données et
le dispositif de réduction de données suivant l'une quelconque des revendications 7 à 9, le dispositif de réduction de données étant conçu pour effectuer une réduction de données des trains de données fournies par la pluralité de capteurs (110-i).

12. Produit de programme d'ordinateur conçu pour effectuer le procédé suivant l'une quelconque des revendications 1 à 6.
